Europäisches Patentamt

European Patent Office

Office européen des brevets

(19)

(11) Veröffentlichungsnummer: **0 167 734**

**A1**

(12) # EUROPÄISCHE PATENTANMELDUNG

(21) Anmeldenummer: 85105141.7

(22) Anmeldetag: 26.04.85

(51) Int. Cl.⁴: **H 03 K 17/08**
**H 02 H 9/04**

(30) Priorität: 10.05.84 DE 3417359

(43) Veröffentlichungstag der Anmeldung:
**15.01.86 Patentblatt 86/3**

(84) Benannte Vertragsstaaten:
**AT CH DE FR GB IT LI SE**

(71) Anmelder: Siemens Aktiengesellschaft
Berlin und München Wittelsbacherplatz 2
D-8000 München 2(DE)

(72) Erfinder: Thiele, Gerd, Dipl.-Ing.
Lessingstrasse 3b
D-8520 Erlangen(DE)

(54) **Schutzbeschaltung für einen Thyristor.**

(57) Bei der erfindungsgemäßen Schutzbeschaltung sind als statischer und dynamischer Überspannungsschutz zwischen die Anode und das Glied des Thyristors (1) mehrere, in Serie geschaltete BOD-Elemente ($B_1$ bis $B_n$) geschaltet. Mit Ausnahme des mit dem Gate verbundenen BOD-Elements ($B_n$) sing allen anderen BOD-Elementen ($B_1$ bis $B_n$-1) Parallel-RC-Glieder ($R_1$ bis $R_{n-1}$; $C_1$ bis $C_{n-1}$) parallel geschaltet, deren Widerstands- und Kapazitätswerte gleich groß sing. Dem mit dem Gate verbundenen BOD-Element ($B_n$) und der Kathoden-Gate-Strecke des Thyristors (1) ist ein weiteres Parallel-RC-Glied ($R_n$, $C_n$) parallel geschaltet, dessen Widerstandswert kleiner oder gleich und dessen Kapazitätswert kleiner als die Widerstands- bzw. Kapazitätswerte der anderen RC-Glieder ist. Vorzugsweise ist bei dem letzten RC-Glied ($R_n$, $C_n$) der Widerstandswert sehr klein gegenüber den Widerstandswerten der anderen RC-Glieder und der Kapazitätswert ist vernachlässigbar. Bei dieser bevorzugten Bemessung wird die statische Ansprechspannung durch die nicht direkt mit dem Gate verbundenen BOD-Elemente ($B_1$ bis $B_n$) bestimmt, die dynamische Ansprechcharakteristik ist durch ein Serien-RC-Glied ($R_n$; $C_1$ bis $C_{n-1}$) bestimmt, das von den Kapazitäten aller RC-Glieder und durch den Widerstand bestimmt ist, der zu dem mit dem Gate verbundenen BOD-Element parallel geschaltet ist.

Siemens Aktiengesellschaft          Unser Zeichen
Berlin und München                  VPA 84 P 3 1 6 4 E

Schutzbeschaltung für einen Thyristor

Die Erfindung betrifft eine Schutzbeschaltung für einen Thyristor, mit wenigstens zwei in Serie geschalteten BOD-Elementen, deren Schwellwertspannungen kleiner als die Nullkippspannung des Thyristors ist und die mit gleicher Polung wie der Thyristor zwischen dessen Anode und dessen Gate geschaltet sind.

Eine unerwünschte Zündung von Thyristoren ist möglich, wenn die Anoden-Kathoden-Spannung entweder die Nullkippspannung überschreitet oder innerhalb sehr kleiner Anstiegszeiten (z.B. 2 bis 3 µs) anspringt. Solche unerwünschten Zündungen geschehen in der Regel unkontrolliert an einem beliebigen Fleck innerhalb der Kathodenfläche, wobei es wegen der hohen Einschaltverluste zur Zerstörung des Thyristors führen kann.

Zur Vorbeugung wird daher die ungewollte Zündung bei unzulässigen Spannungen oder Spannungssteilheiten in eine gewollte Schutzzündung mit einem entsprechenden Steuerimpuls am Gate des Thyristors umgewandelt. Bekannt ist aus der DE-OS 24 44 910 eine Schutzbeschaltung, die sowohl statisch, als auch dynamisch arbeitet, d.h. einen Schutz sowohl gegen Überschreiten der Nullkippspannung, als auch bei Überschreiten von zulässigen $\frac{dU}{dt}$ Werten bietet.

Aus dem Cigré report 14-05/19, 1976 ist die eingangs beschriebene Schutzbeschaltung bekannt, die in der mit "Nelson River" bezeichneten Hochspannungs-Gleichstrom-Übertragung (HGÜ) eingesetzt ist. Bei dieser Schaltung

Soe 2 Bim / 03.05.1984

0167734

wird der Schutz gegen das Überkopfzünden der Thyristoren beim Überschreiten ihrer Nullkippspannung mit Hilfe von Hochspannungskippdioden, auch BOD-Elemente (break over diode) genannt, erhalten, die zwischen Anode und Gate des zu schützenden Thyristors geschaltet sind. Dabei sind mehrere BOD-Elemente in Reihe geschaltet, mit parallel geschalteten hochohmigen Widerständen zur Spannungsstabilisierung. Der Vorteil dieser Schutzbeschaltung mit BOD-Elementen besteht darin, daß bei Überschreiten der Kippspannung bzw. Schwellwertspannung der BOD-Elemente ein gezielter Steuerimpuls auf den Thyristor gegeben wird, wobei zusätzlich während der Zündverzugszeit der BOD-Elemente und insbesondere des zu schützenden Thyristors im Zusammenhang mit der Ventilschutzdrossel oder der Streuinduktivität des Transformators bereits eine Spannungsbegrenzung erfolgt. Eine Zündung beim Überschreiten von für den Thyristor zulässigen $\frac{dU}{dt}$ Werten wird jedoch nicht ausgelöst, d.h. diese Schutzbeschaltung wirkt nicht dynamisch.

Es besteht die Aufgabe, eine Schutzbeschaltung der eingangs genannten Art so auszugestalten, daß sie unter Beibehaltung der genannten Vorteile auch dynamisch wirkt, d.h. eine Schutzzündung auch beim Überschreiten der zulässigen $\frac{dU}{dt}$ Werte auslöst.

Erfindungsgemäß wird diese Aufgabe dadurch gelöst, daß mit Ausnahme des mit dem Gate verbundenen BOD-Elements allen anderen BOD-Elementen ein Parallel-RC-Glied parallel geschaltet ist, wobei Widerstands- und Kapazitätswerte dieser RC-Glieder gleich groß sind und daß dem mit dem Gate verbundenen BOD-Element und der Kathoden-Gate-Strecke des Thyristors ein weiteres Parallel-RC-Glied parallel geschaltet ist, dessen Kapazitätswert kleiner und dessen Widerstandswert gleich oder kleiner als der Kapazitäts- bzw. Widerstandswert der anderen RC-Glieder ist.

Bei der erfindungsgemäßen Schutzbeschaltung wird durch einen kapazitiv verstimmten Spannungsteiler parallel zur Serienschaltung der BOD-Elemente eine Abhängigkeit des Ansprechens von der Spannungssteilheit erreicht.

Vorteilhaft ist es, bei dem Parallel-RC-Glied des mit dem Gate verbundenen BOD-Elements den Widerstandswert sehr klein und den Kapazitätswert vernachlässigbar im Vergleich zum Widerstands- bzw. Kapazitätswert der anderen Parallel-RC-Glieder zu wählen.

Mit dieser Bemessung wird eine Trennung der Aufgaben insofern erreicht, als das mit dem Gate des Thyristors direkt verbundene BOD-Element zusammen mit einem Serien-RC-Glied die $\frac{dU}{dt}$ abhängige Zündung übernimmt, während die anderen BOD-Elemente für das statische Ansprechen bestimmt sind. Dabei wird das Serien-RC-Glied von den Kondensatoren der Parallel-RC-Glieder zusammen mit dem Widerstand gebildet, der das BOD-Element und zusätzlich die Kathoden-Gate-Strecke des Thyristors überbrückt.

Vorzugsweise ist zu dem mit dem Gate verbundenen BOD-Element eine Diode antiparallel geschaltet. Mit dieser Diode wird verhindert, daß beim Zünden des Thyristors die Spannung der Kondensatoren der Parallel-RC-Glieder rückwärts über das mit dem Gate verbundene BOD-Element sehr kurzzeitig einen Strom treiben, der dieses BOD-Element erfahrungsgemäß zerstören kann.

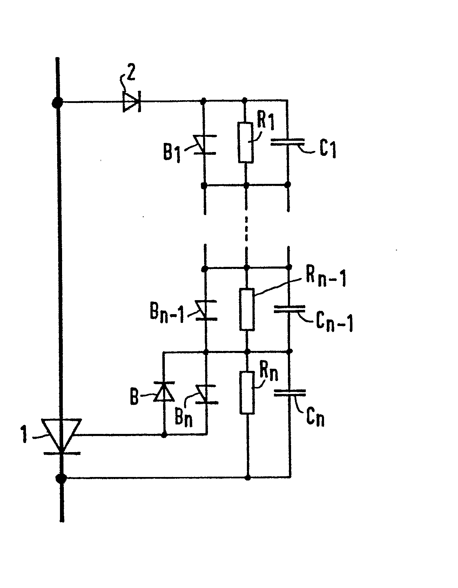

Im folgenden wird die erfindungsgemäße Schutzbeschaltung beispielhaft anhand der Figur näher erläutert.

Die Figur zeigt einen Thyristor 1, dessen Anode über eine Sperrdiode 2 und n BOD-Elemente $B_1$ bis $B_n$ mit seinem Gate verbunden ist. Jedem nicht unmittelbar mit dem Gate verbundenen BOD-Element $B_1$ bis $B_{n-1}$ ist jeweils

ein Parallel-RC-Glied mit den Widerständen $R_1$ bis $R_{n-1}$ und den Kondensatoren $C_1$ bis $C_{n-1}$ parallel geschaltet. Alle Widerstände $R_1$ bis $R_{n-1}$ besitzen den gleichen Widerstandswert R und alle Kondensatoren $C_1$ bis $C_{n-1}$ besitzen den gleichen Kapazitätswert C. Dem mit dem Gate des Thyristors 1 unmittelbar verbundenen BOD-Element $B_n$ und der Kathoden-Gate-Strecke des Thyristors 1 ist ein weiteres Parallel-RC-Glied mit dem Widerstand $R_n$ und $C_n$ parallel geschaltet. Zu dem mit dem Gate des Thyristors 1 direkt verbundenen BOD-Element $B_n$ ist auch noch eine Freilaufdiode 3 antiparallel geschaltet.

Zur Erklärung der Wirkungsweise der Schutzbeschaltung wird die Spannung $u_n(t)$ betrachtet, die am RC-Glied mit dem Widerstand $R_n$ und $C_n$ bei gesperrtem Thyristor 1 ansteht. Diese Spannung beträgt (Gleichung (1)):

$$u_n(t) = S \cdot \frac{R_n}{(n-1) \cdot R + R_n} \left\{ t + \frac{(n-1) \cdot R}{(n-1) \cdot R + R_n}(\tau - \tau_n) \cdot \left[ 1 - e^{-\frac{t}{\tau_r}} \right] \right\}$$

mit:
$$\tau = R \cdot C$$
$$\tau_n = R_n \cdot C_n$$
$$\tau_r = \frac{(n-1) \cdot R \cdot R_n}{(n-1) \cdot R + R_n} \left( \frac{C}{n-1} + C_n \right)$$

worin S die Steilheit der Spannung ist, die näherungsweise von der Anlagenkapazität und deren Entladungsstrom bestimmt ist. Vereinfacht man Gleichung (1) mit $R_n = R$, so erhält man:

$$u_n(t) = \frac{S}{n} \cdot \left\{ t + \frac{n-1}{n} \cdot (\tau - \tau_n) \cdot \left[ 1 - e^{-\frac{t}{\tau_r}} \right] \right\} \tag{2}$$

mit
$$\tau_r = \frac{n-1}{n} \cdot R \cdot \left( \frac{C}{n-1} + C_n \right)$$

Die zeitliche Ableitung dieser Spannung beträgt:

$$\frac{du_n}{dt} = \frac{S}{n} \left\{ 1 + \frac{(n-1)(C - C_n)}{C + (n-1) C_n} e^{-\frac{t}{\tau_r}} \right\} \tag{3}$$

Für t = 0 erhält man

$$\left(\frac{du_n}{dt}\right)_{t=0} = \frac{S}{n} \cdot \frac{n \cdot C}{C + (n-1) \cdot C_n} \tag{4}$$

mit

$$\left(\frac{du_n}{dt}\right)_{t=0} = \frac{S}{n} \quad \text{für } C_n = C,$$

$$\left(\frac{du_n}{dt}\right)_{t=0} > \frac{S}{n} \quad \text{für } C_n < C,$$

$$\left(\frac{du_n}{dt}\right)_{t=0} < \frac{S}{n} \quad \text{für } C_n > C.$$

Das bedeutet, daß für $C_n > C$ die Spannung $U_n(t)$ steiler ansteigt und damit früher eine dynamische Schutzzündung auslöst, als es der statischen Ansprechschwelle $\frac{S}{n}$ entspricht. Unter Berücksichtigung der Anlagenkapazität und deren Entladungsstrom läßt sich die Größe der Kapazität $C_n$ so bestimmen, daß eine dynamische Schutzzündung für

$$\frac{du_n}{dt} > 1 \frac{kV}{\mu S}$$ gezielt mit einem ausreichend großen Zündimpuls ausgelöst wird. Die statische Ansprechschwelle bleibt dabei weiterhin durch die n in Serie geschalteten BOD-Elemente bestimmt.

In einer weiteren Vereinfachung wird für Gleichung (1) angenommen $R_n \ll R$, $C \gg C_n \longrightarrow 0$. Daraus ergibt sich:

$$u_n(t) = S \cdot \frac{R_n \cdot C}{n-1} \cdot \left(1 - e^{-\frac{t(n-1)}{R_n C}}\right) \tag{5}$$

und

$$\frac{du_n}{dt} = S \cdot e^{-\frac{t(n-1)}{R_n C}} \tag{6}$$

Bei dieser Bemessung ist das n-te BOD-Element $B_n$ zusammen mit dem aus den Kondensatoren $C_1$ bis $C_{n-1}$ und dem Widerstand $R_n$ gebildeten Serien RC-Glied für die $\frac{dU}{dt}$ abhängige Zündung verantwortlich, wobei die

0167734

Kapazitäten $C_1$ bis $C_{n-1}$ einen dynamischen Nebenschluß zu den Widerständen $R_1$ bis $R_{n-1}$ bilden und zusammen mit $R_n$ die dynamische Ansprechcharakteristik mit der Zeitkonstanten $R_n \cdot \frac{C}{n-1}$ bestimmen. Weiterhin führen die Kondensatoren $C_1$ bis $C_{n-1}$ die notwendige Ladung zum Zünden des Thyristors nach Ansprechen des BOD-Elements $B_n$. Aus Grenzbetrachtungen läßt sich abschätzen, daß die Zahl der in Serie geschalteten BOD-Elemente $B_1$ bis $B_{n-1}$ für eine gute dynamische Ansprechcharakteristik etwa 4 bis 5 beträgt.

Die übrigen BOD-Elemente $B_1$ bis $B_{n-1}$ bestimmen zusammen mit der Genauigkeit ihrer parallelen Stabilisierungswiderstände $R_1$ bis $R_n$ die statische Ansprechspannung.

Es zeigte sich, daß die Schaltungsvariante mit $R_n \quad R$ und $C_n \quad 0$ in ihrem statischen und dynamischen Ansprechverhalten wesentlich günstiger ist als die zuerst betrachtete Schaltungsvariante mit $R_n = R$.

Beim Zünden des Thyristors 1 kann die Spannung an den Kondensator $C_1$ bis $C_{n-1}$ sehr kurzzeitig einen Strom rückwärts über die Sperrdiode 2 und das BOD-Element $B_n$ treiben. Dieser Strom ist von der Sperrverzögerungsladung der Sperrdiode 2 abhängig und kann gegebenenfalls das BOD-Element $B_n$ zerstören. Mit der zum BOD-Element $B_n$ antiparallel geschalteten Diode 3 wird diese Gefahr gebannt.

3 Patentansprüche
1 Figur

Patentansprüche

1. Schutzbeschaltung für einen Thyristor, mit wenigstens zwei in Serie geschalteten BOD-Elementen, deren Schwellwertspannungen kleiner als die Nullkippspannung des Thyristors ist und die mit gleicher Polung wie der Thyristor zwischen dessen Anode und dessen Gate geschaltet sind, d a d u r c h   g e k e n n z e i c h n e t ,   daß mit Ausnahme des mit dem Gate verbundenen BOD-Elements ($B_n$) allen anderen BOD-Elementen ($B_1$ bis $B_{n-1}$) ein Parallel-RC-Glied ($R_1$ bis $R_{n-1}$; $C_1$ bis $C_{n-1}$) parallel geschaltet ist, wobei Widerstands- und Kapazitätswerte dieser RC-Glieder gleich groß sind und daß dem mit dem Gate verbundenen BOD-Element ($B_n$) und der Kathoden-Gate-Strecke des Thyristors (1) ein weiteres Parallel-RC-Glied ($R_n$; $C_n$) parallel geschaltet ist, dessen Kapazitätswert kleiner und dessen Widerstandswert gleich oder kleiner als der Kapazitäts- bzw. Widerstandswert der anderen RC-Glieder ist.

2. Schutzbeschaltung nach Anspruch 1,   d a d u r c h   g e k e n n z e i c h n e t ,   daß bei dem Parallel-RC-Glied des mit dem Gate verbundenen BOD-Elements ($B_n$) der Widerstandswert sehr klein und der Kapazitätswert vernachlässigbar im Vergleich zum Widerstands- bzw. Kapazitätswert der anderen Parallel-RC-Glieder ($R_1$ bis $R_{n-1}$; $C_1$ bis $C_{n-1}$) ist.

3. Schutzbeschaltung nach Anspruch 1 oder 2, d a d u r c h   g e k e n n z e i c h n e t ,   daß zu dem mit dem Gate verbundenen BOD-Element ($B_n$) eine Diode (3) antiparallel geschaltet ist.

))) Europäisches
Patentamt

## EUROPÄISCHER RECHERCHENBERICHT

## EINSCHLÄGIGE DOKUMENTE

| orie | Kennzeichnung des Dokuments mit Angabe, soweit erforderlich, der maßgeblichen Teile | Betrifft Anspruch | KLASSIFIKATION DER ANMELDUNG (Int. Cl 4) |
|------|---|---|---|
| A | DE-A-2 444 910 (SIEMENS)<br>* Figur 3; Seite 4, Zeilen 21-33 *<br><br>--- <br><br>DE-A-3 134 840 (BBC)<br><br>---<br><br>BBC-NACHRICHTEN, Band 59, Nr. 3/4, 1977, Seiten 152-158; P. WETZEL: "Thyristorschutz mit Halbleitern - wirtschaftlich und sicher"<br><br>----- | 1 | H 03 K  17/08<br>H 02 H   9/04 |

|  |  |
|---|---|
|  | RECHERCHIERTE SACHGEBIETE (Int. Cl 4) |
|  | H 03 K<br>H 02 H |

Der vorliegende Recherchenbericht wurde für alle Patentansprüche erstellt.

| Recherchenort<br>DEN HAAG | Abschlußdatum der Recherche<br>19-06-1985 | Prüfer<br>KOLBE W.H. |
|---|---|---|

KATEGORIE DER GENANNTEN DOKUMENTEN
von besonderer Bedeutung allein betrachtet
von besonderer Bedeutung in Verbindung mit einer
anderen Veröffentlichung derselben Kategorie
technologischer Hintergrund
nichtschriftliche Offenbarung
Zwischenliteratur
der Erfindung zugrunde liegende Theorien oder Grundsätze

E : älteres Patentdokument, das jedoch erst am oder
nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument